# EUROPEAN PATENT SPECIFICATION

(11) **EP 1 311 032 B1**
(45) Date of publication and mention of the grant of the patent: **20.09.2006**
(21) Application number: 03000664.7
(22) Date of filing: 10.10.1997
(51) Int. Cl.: H01R 12/32

(54) **High density connector and method of manufacture**
Steckverbinder hoher Kontaktdichte und Herstellungsverfahren
Connecteur à haute densité et procedé de fabrication

(30) Priority: 10.10.1996 US 728194; 31.12.1996 US 777579; 31.12.1996 US 778380; 31.12.1996 US 778398; 31.12.1996 US 777806
(43) Date of publication of application: 14.05.2003
(62) Divisional of application: 97117583.1
(73) Proprietor: FCI, 78000 Versailles (FR)
(72) Inventor: Lemke, Timothy A., Dillsburg, Pennsylvania 17019 (US); Houtz, Timothy W., Etters, Pennsylvania 17319 (US)
(74) Representative: Beetz & Partner

(56) References cited:
- EP-A- 0 843 383
- WO-A-94/13034
- US-A- 5 483 407
- US-A- 5 515 604

## Description

The present invention relates to an electrical high density connector of the kind referred to in the preamble portion of patent claim 1. Such an electrical connector is known from WO 94/ 13034 A.

The drive to reduce the size of electronic equipment, particularly personal portable devices, and to add additional functions to such equipment, has resulted in an ongoing drive for miniaturization of all components, especially electrical connectors. Efforts to miniaturize connectors have included reducing the pitch between terminals in single or double row linear connectors, so that a relatively high number of I/O or other lines can be interconnected by connectors that fit within tightly circumscribed areas on the circuit substrates allotted for receiving connectors. The drive for miniaturization has also been accompanied by a shift in preference to surface mount techniques (SMT) for mounting components on circuit boards. The confluence of the increasing use of SMT and the required fine pitch of linear connectors has resulted in approaching the limits of SMT for high volume, low cost operations. Reducing the pitch of the terminals increases the risk of bridging adjacent solder pads or terminals during reflow of the solder paste. To satisfy the need for increased I/O density, array connectors have been proposed. Such connectors have a two dimensional array of terminals mounted on an insulative substrate and can provide improved density. However, these connectors present certain difficulties with respect to attachment to the circuit substrates by SMT techniques because the surface mount tails of most, if not all, of the terminals must be beneath the connector body. As a result, the mounting techniques used must be highly reliable because it is difficult to visually inspect the solder connections or repair them, if faulty. In the mounting of an integrated circuit (IC) on a plastic or ceramic substrate the use of ball grid array (BGA) and other similar packages has become common. In a BGA package, spherical solder balls attached to the IC package are positioned on electrical contact pads of a circuit substrate to which a layer of solder paste has been applied, typically by use of a screen or mask. The unit is then heated to a temperature at which the solder paste and at least a portion or all of the solder ball melt and fuse to an underlying conductive pad formed on the circuit substrate. The IC is thereby connected to the substrate without need of external leads on the IC.

In many recent patents efforts for miniaturization of products using a SMT technology appear.

The patent application WO 98 / 15990 discloses a Ball Grid Array (BGA) technology applied to a low profile board-to-board connector system where only the reduction of the height of the assembly is required. In this purpose, contacts and solder elements are designed to be the most compact as possible.

WO 97/20454 discloses a high density connector able to connect an electronic package comprising solder elements and a circuit board in which the contact includes a surface mount section having a convex bottom surface with a shape which simulates at least a lower portion of a sphere and which mimics a solder ball.

US-A 5593322 relates to a high density connector having fuse ball contacts located at the surface of the bottom of a male connector to connect a component to the surface of a PCB according to the well known BGA technology in which plastic supports provided on their four surfaces with metal strips are connected to a pad located at the bottom of the surface of the insulation body. Then the connector is solded to the PCB by means of a solder ball attached to the pads.

It is also known from US-A 4 767 344 that an electrical connection can be carried out by a body of reflowable material. However, as an amount of solder encircles the pin contact and envelops a predetermined region along the length of the pin this process is not applicable to a high density (with a small pitch between the rows and the columns) connector of the surface mounted type.

The patent application WO 96/42123 filed by the same applicant discloses components using contacts with a lower section comprising a bent terminal tab where the fusible material is applied to the bent surface of the tabs.

EP 0591772 A1 teaches another way to sold connectors to a multi layers PCB using contact pads. However this teaching is limited to components without contacts located in an insulation housing.

US-A 5 495 668 teaches the use of links between a semi conductor chip and a printed circuit board. Links are performed by means of wires provided at their ends with solder bumps. Once again, the components are not located in an insulation housing.

US-A 5 131 871 relates to a design able to reduce the stress in a connector block in a high density connector. As the walls specifying an aperture are thin the invention offers to strengthen it by using projections. These projections provide supporting means for a contact but does not secure the contact by deformation.

US-A 5 358 417 teaches a power connector using an insulative body through which a plurality of cables extend. The contact of the end of these cables occurs onto a pad and wires of these cables are mated by a conductive gel able to maintain wires and pad in abutment without solder balls.

EP 0782220-A2 relates to gripping means provided within apertures located in a body. Gripping means are performed by latches acting on conductive cables of ribbon cables.

Other patents were applied for inventions made to limit the wicking effect during the welding process. For example WO 97/45896 teaches a small connector for mobile phone where the length of the contact is short between its two ends. As one of the ends is dedicated to be the surface receiving the solder for surface mount process, only one portion of this contact has a nickel plating to prevent solder wicking.

US-A 3 864 004 discloses a circuit board socket with a portion of the spring contact coated with a solder resist coating in order to assure that any molten solder wicking does not flow up onto spring.

DE PS 3 712 691 teaches also a coated electrical pin comprising an intermediate nickel layer acting as anti-diffusion barrier.

US-A 5 453 017 discloses the use of a layer of non-solderable material as coating such that solder doesn't adhere to longitudinal side.

While the use of BGA and similar systems in connecting an IC to a substrate has many advantages, a corresponding means for mounting an electrical connector or similar component on a printed wiring board (PWB) or other substrate has yet to be developed. It is important for most situations that the substrate-engaging surfaces of the solder balls are coplanar to form a substantially flat mounting interface, so that in the final application the balls will reflow and solder evenly to a planar printed circuit board substrate. Any significant differences in solder coplanarity on a given substrate can cause poor soldering performance when the connector is reflowed onto a printed circuit board. To achieve high soldering reliability, users specify very tight coplanarity requirements, usually on the order of 0.102 mm (0.004 inches). Coplanarity of the solder balls is influenced by the size of the solder ball and its positioning on the connector. The final size of the ball is dependent on the total volume of solder initially available in both the solder paste and the solder balls. In applying solder balls to a connector contact, this consideration presents particular challenges because variations in the volume of the connector contact received within the solder mass affect the potential variability of the size of the solder mass and therefore the coplanarity of the solder balls on the connector along the mounting interface. Another problem presented in soldering connectors to a substrate is that connectors often have insulative housings which have relatively complex shapes, for example, ones having numerous cavities. Residual stresses in such thermoplastic housings can result from the molding process, from the build up of stress as a result of contact insertion or a combination of both. These housings may become warped or twisted either initially or upon heating to temperatures necessary in SMT processes, such as temperatures necessary to reflow the solder balls.

Such warping or twisting of the housing can cause a dimensional mismatch between the connector assembly and the PWB, resulting in unreliable soldering because the surface mounting elements, such as solder balls, are not sufficiently in contact with the solder paste or close to the PWB prior to soldering.

WO 94/ 13034 A discloses an electrical high density connector arranged in an array of a plurality of rows and columns to be mounted onto the surface of a substrate having conductive elements comprising contacts with a lower section having a terminal tab, adapted to be electrically connected to one of the said conductive elements, a base section lodging said array of contacts formed by an insulating material, the base having an exterior side adapted to face the substrate

It is an object of the present invention to provide an electrical high density connector, which can be reliably and efficiently mounted on substrates by surface mounting techniques.

This is achieved by an electrical high density connector having the features of claim 1.

Electrical connectors according to the present invention provide high I/O density and reliable attachment to circuit substrates by SMT techniques. These connectors exhibit high coplanarity along the mounting interface.

Electrical connectors of the present invention are ones in which one or more terminals are connectable by a fusible electrically conductive material to a substrate. This fusible electrically conductive material is a solder ball that can be reflowed to provide the primary electrical current path between the terminal and a circuit substrate.

### Brief Description of the Drawings

The electrical high density connector of the present invention is further described with reference to the accompanying drawings in which:
- Fig. 1: is a top plan view of a first preferred embodiment of a receptacle connector of the present invention;
- Fig. 2: is an end view of the receptacle shown in Fig. 1;
- Fig. 3: is a top plan view of said first preferred embodiment of a plug connector of the present invention;
- Fig. 4: is an end view of the plug shown in Fig. 3;
- Fig. 5: is an end view of the mated receptacle and plug shown in Figs. 1-4;
- Fig. 6: is a top plan view of a receptacle used in a second preferred embodiment of a receptacle connector of the present invention;
- Fig. 7: is an end view of the receptacle shown in Fig. 1;
- Fig. 8: is a top plan view of the plug element of the second preferred embodiment of a plug connector of the present invention;
- Fig. 9: is an end view of the plug element;
- Fig. 10: is an end view of the mated receptacle and plug shown in Figs. 6-9.

### Detailed Description of the Preferred Embodiments

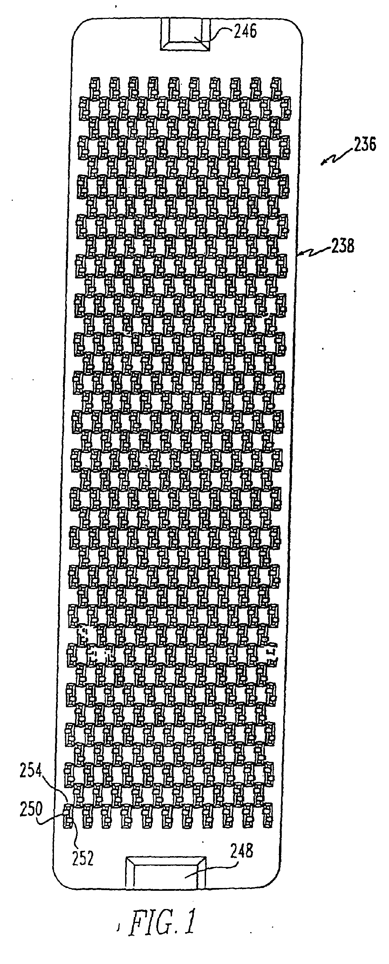

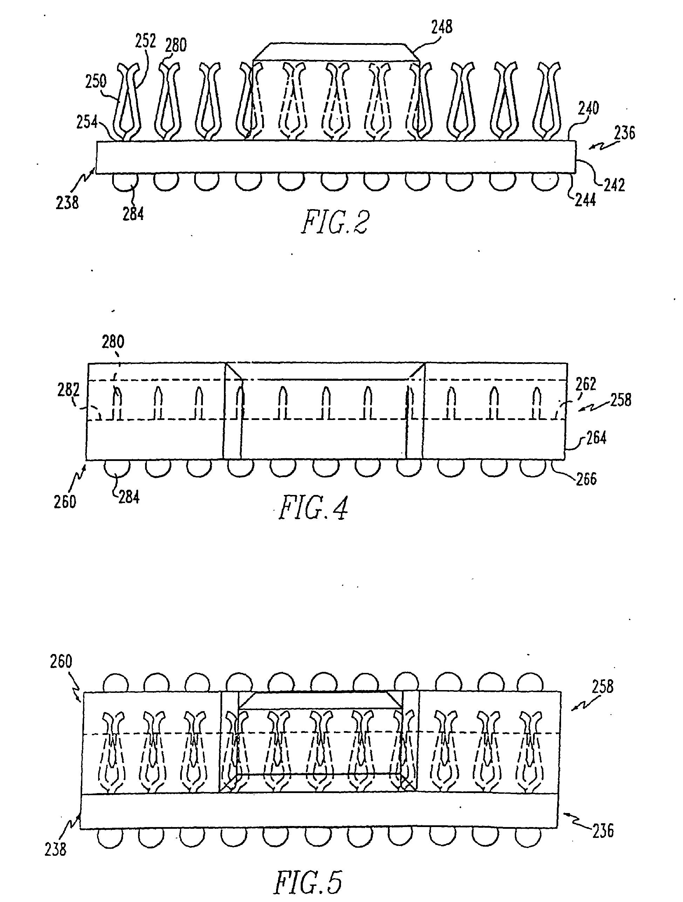

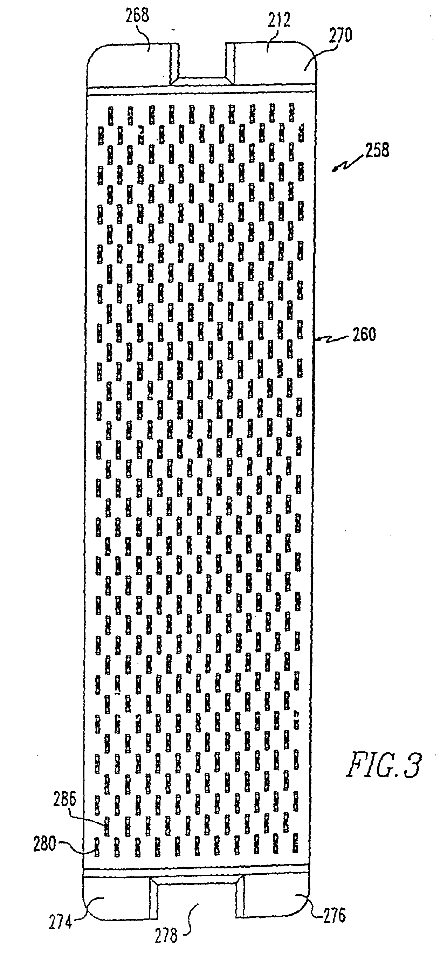

Figs. 1-5 illustrate a preferred embodiment of a set of intermating connectors of this invention. Referring particularly to Fig. 1 and 2, this set includes a receptacle shown generally at numeral 236.

This receptacle includes an insulative housing shown generally at 238 which has an inner side 240, a lateral side 242 and an exterior side 244. The housing also includes opposed alignment projections 246 and 248. On the inner side of the housing there are contacts 250 and 252 each having sections which bow away from each other and then converge to a contact point from which then again diverge. Contacts 251 are mounted on base 231. Solder balls, such as solder ball 254, are mounted to the board side of contacts 250 and 252 in the same manner as described above. Referring particularly to Fig. 3 and 4, the set also includes a plug shown generally at 258 which includes an insulative housing shown generally at 260 having an inner side 262, a peripheral lateral side 264 and an exterior side 266. At one end of the housing there are a pair of vertical end walls 268 and 270 with a medial end recess 272. At the opposed end of the housing there are another pair of end walls 274 and 276 with a medial end recess 278. Extending from the inner side of the housing there are a plurality of contacts as at contact 280 that extend from recesses as at 282. Onto each of these contacts is fused a solder ball 284. It will also be seen that these contacts are positioned in a staggered arrangement. For example, contact 286 is offset with respect to contact 280, so rows of contacts can be spaced closer together to increase contact density. Referring particularly to Fig. 5, it will be seen that each contact in the plug such as contact 280 is vertically aligned with one of the pairs of converging contacts, such as contacts 250 and 252, in the receptacle and is interposed between these converging contacts. It will also be seen that the alignment projections 246 and 248 also engage the end recesses 272 and 278 in the plug.

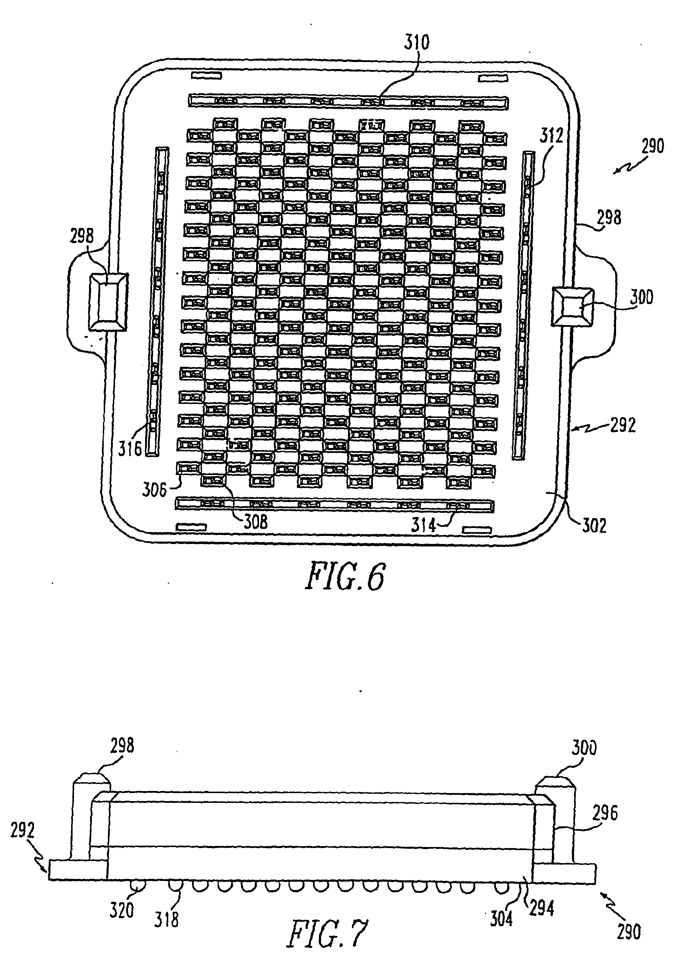

Figs. 6-10 show a second preferred embodiment of a set of intermating connectors. The plug is shown generally at numeral 290.

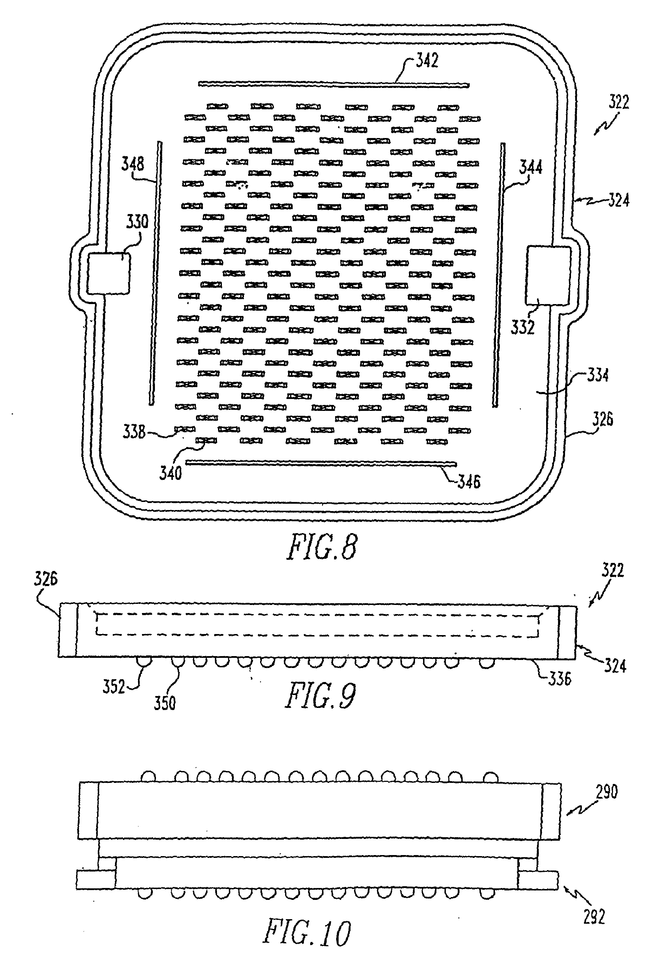

This plug includes a housing generally 292 having a base wall 294 and a peripheral lateral wall 296, as well as opposed alignment projections 298 and 300. The base wall of the housing has an inner side 302 and an outer side 304. Signal contacts, such as contact 306, extend from inner side 302. It will be seen that the signal contacts are also staggered or offset in alternate rows, to increase contact density. The plug also includes ground or power contacts 310, 312, 314 and 316 arranged adjacent each of the sides of the plug parallel to one side of the lateral wall. On the exterior side of the base wall are signal contact solder balls, such as solder ball 318, and power ground contact solder balls, such as 320, which are fused to their respective contacts in the same way as described with respect to the first embodiment. The receptacle is shown generally at numeral 322 and has an insulative housing 324 that includes a base wall 326, a peripheral lateral wall 328 and alignment projection receiving recesses 330 and 332. The base wall also has an exterior side 334 and an inner side 336. Projecting from the inner side are signal contacts such as contacts 338 and 340. The contacts in adjacent transverse rows are also axially offset to allow an increase in contact density. Parallel to each side of the peripheral wall there are lateral power or ground contacts 342, 344, 346 and 350. On the exterior side of the base wall there are for each signal contact a solder ball, such as solder ball 352. There are also solder balls, such as at solder ball 354, for attaching each of the power or ground pins. Referring particularly to Fig. 10, it will be seen that at the plug 290 engages receptacle 322.

As previously mentioned, components such as electrical connectors, that are to be mounted on circuit substrates by SMT techniques must meet very demanding specifications for coplanarity. If tight tolerances on coplanarity, usually on the order of about 0.08 - 0.1 mm (0.003 to about 0.004 inch), are not maintained, manufacturers experience undesirably high failure rates resulting from faulty solder connections. Variations in the distance of a surface mount portion of a contact from the circuit substrate can result from variations in the location of the contact in the insulative housing occurring as a result of the contact insertion process and from deformation of the housings, resulting in bowing or warping of the mounting interface of the connector body. Connectors made in accordance with the present invention are capable of attaining strict coplanarity requirements by use of features that carefully locate and size the fusible bodies used for bonding the connector to a substrate and by the use of contact securing arrangements that prevent accumulations of stresses in the connector housing that tend to distort the housing.

In the embodiments of Figs. 1-10 the metal contacts are secured in insulative housings in a manner to avoid the inducing of stress in the body of the housing. This securing is achieved by the use of a shaped slot or opening into which a securing portion of the contact is inserted. In one arrangement especially useful for the smaller signal contacts, the slot has a shape that closely conforms in shape and dimensions to all the surfaces of the contact but one. The wall of the slot facing that one surface has an integrally molded lateral projection projecting into the slot. The distance between the distal end of the projection and the opposing wall of the slot is less than the thickness of the contact. Thus, the distal portion of the projection is engaged by and deformed by the contact as it is inserted into the slot. The contact is held securely in the slot by the normal force exerted on the contact by the deformable projection. Because the distal of the projection is free to deform, the build up of stresses in the housing is avoided. In the preferred embodiments illustrated, the projection comprises a pyramidal rib integrally formed on one of the side walls of the slot.

Those skilled in the art will also appreciate the particular shape, size, number and placement of such ribs may vary for different types of housings, and these factors would be selected so that, to the greatest extent possible, stresses in the housing are isolated in the deformable ribs.

As previously mentioned, another factor influencing coplanarity of the substrate mounting face of a connector utilizing BGA mounting is the uniformity of the size of the solder balls and the position of the solder balls with respect to the board mounting face of the connector housing. In the preferred embodiments previously described, the termination tab of each contact is positioned in a passageway. The outer passageways are substantially uniform in size and shape. These passageways provide several features of importance with respect to the present invention. The passageways can receive a highly uniform amount of solder paste placed therein, for example, by a simple deposit and squeegee operation. Thus, the amount of solder available for securing each solder ball onto a contact is substantially uniform. The passageways locate the position of each solder ball in the lateral X - Y directions prior to attachment of the solder balls onto the contacts. The passageways also locate the solder balls in the Z direction with respect to the bottom surface of the housing and the distance of the solder ball from the terminal tabs of the contacts. The nominal extension of the tab into the passageway is set so that at the maximum of the tolerance for extension of the tab into the passageway, the tab does not touch the solder ball and thereby influence its Z direction location. However, fusing of the solder ball onto the contact tab is assured by having a relatively uniform and adequate amount of solder, from the solder paste, in the passageway. Any variation in the distance between the contact tab and the solder ball is absorbed by the variable volume of solder paste placed in the passageway.

In order to maintain an adequate amount of solder adjacent the solder ball during the reflow step used to attach the solder balls onto the contacts and to prevent solder wicking onto the engagement surfaces of the contact, the contact is treated to resist solder wicking.

It will be appreciated that electrical connector has been described in which the connector that can utilize BGA technologies for mounting on a PWB. Surprisingly and unexpectedly it was also found that there was a relatively high degree of uniformity in the profiles of the solder balls and, in particular, in the weights and/or volume of the solder balls.

While the present invention has been described in connection with the preferred embodiments of the various figures, it is to be understood that other similar embodiments may be used or modifications and additions may be made to the described embodiment for performing the same function of the present invention without deviating therefrom. Further, the arrangements described can be used with respect to components other than connectors, that comprise housings formed of insulative materials which carry elements to be fused onto a PWB or other electrical substrate.

Therefore, the present invention should not be limited to any single embodiment, but rather construed in scope in accordance with the recitation of the appended claims.

## Claims

1. An electrical high density connector having contacts arranged in an array of a plurality of rows and columns to be mounted onto the surface of a substrate having conductive elements comprising:
- contacts with a lower section (80, 98, 188), having a terminal tab, adapted to be electrically connected to one of the said conductive elements;
- a base section lodging said array of contacts formed by an insulating material (12, 152), the base having an exterior side adapted to face the substrate;
**characterized by**
- solder balls (82, 190) fused onto each terminal tab after insertion into passageways of said base section, said solder balls (82, 190) being adapted to provide the primary electrical current path between the connector and the substrate.

2. An electrical high density connector according to claim 1 **characterized in that** said contacts are offset in offset staggered rows or columns.

## Patentansprüche

1. Steckverbinder hoher Kontaktdichte mit in einer Matrix bestehend aus mehreren Zeilen und Spalten angeordneten Kontakten zur Montage auf der Oberfläche eines Substrates mit leitenden Elementen, mit:
- Kontakten mit einem unteren Bereich (80, 98, 188), der eine Anschlussfahne zur elektrischen Verbindung mit einem der leitenden Elemente aufweist;
- einen Basisbereich aus isolierendem Material (12, 152) in dem die Kontaktmatrix aufgenommen ist, wobei der Basisbereich eine Außenseite aufweist, die gegenüber dem Substrat anordbar ist, **gekennzeichnet durch**
- Lötzinnkugeln (82, 190), die auf jede Anschlussfahne nach der Einführung in Öffnungen im Basisbereich aufgeschmolzen sind, wobei die Lötzinnkugeln (82, 190) einen primären elektrischen Strompfad zwischen dem Steckverbinder und dem Substrat herstellen.

2. Elektrischer Steckverbinder nach Anspruch 1, **dadurch gekennzeichnet, dass** die Kontakte in versetzten Zeilen und Spalten angeordnet sind.

## Revendications

1. Connecteur électrique à haute densité ayant des contacts agencés dans une matrice d'une pluralité de rangées et colonnes devant être monté sur la surface d'un substrat ayant des éléments conducteurs comprenant :
- des contacts avec une section inférieure (80, 98, 188), ayant une languette terminale, adaptée pour être connectée électriquement à un desdits éléments conducteurs ;
- une section de base logeant ladite matrice de contacts formée par un matériau isolant (12, 152), la base ayant un côté extérieur adapté pour faire face au substrat ;
**caractérisé par**
- des billes de soudure (82, 190) fondues sur chaque languette terminale après insertion dans les passages de ladite section de base, lesdites billes de soudure (82, 190) étant adaptées pour fournir le trajet de courant électrique primaire entre le connecteur et le substrat.

2. Connecteur électrique à haute densité selon la revendication 1, **caractérisé en ce que** lesdits contacts sont décalés en rangées ou colonnes décalées en quinconce.
